Europäisches Patentamt

European Patent Office

Office européen des brevets

(19)

(11) Publication number: **0 030 125**
A1

# (12) EUROPEAN PATENT APPLICATION

(21) Application number: **80304252.2**

(22) Date of filing: **27.11.80**

(51) Int. Cl.³: **H 03 F 1/48**
**H 04 B 3/36, H 03 F 1/26**

(30) Priority: **28.11.79 JP 154035/79**

(43) Date of publication of application:
**10.06.81 Bulletin 81/23**

(84) Designated Contracting States:
**AT BE CH DE FR GB IT LI LU NL SE**

(71) Applicant: **FUJITSU LIMITED**
**1015, Kamikodanaka Nakahara-ku**
**Kawasaki-shi Kanagawa 211(JP)**

(72) Inventor: **Ogawa, Tadao**
**3-19-36, Minamidaira Hino-shi**
**Tokyo, 191(JP)**

(72) Inventor: **Yamaguchi, Nobuhide**
**3-1-3, Minamiogikubo Suginami-ku**
**Tokyo 167(JP)**

(74) Representative: **Bedggood, Guy Stuart et al,**
**Haseltine Lake & Co. Hazlitt House 28 Southampton**
**Buildings Chancery Lane**
**London WC2A 1AT(GB)**

(54) Low noise amplifier circuit.

(57) Transistor (4) of the amplifier, which is in a grounded emitter configuration, has a parallel feedback loop circuit of impedance (ZF) and a series feedback loop circuit of impedance (ZE). The impedance (ZF) is lower at low frequencies and higher at high frequencies, whilst impedance (ZE) is higher at low frequencies and lower at high frequencies. A pole and a zero point of impedance (ZF) coincide with a zero point and a pole of impedance (ZE) respectively.

The amplifier offers a constant input impedance over a wide frequency band, a gain which is higher at high frequencies and a good overload characteristic.

EP 0 030 125 A1

./...

Croydon Printing Company Ltd.

Fig. 2

-1-

LOW NOISE AMPLIFIER CIRCUIT

This invention relates to a low noise amplifier circuit.

A digital transmission system which transmits digital signals using a transmission path or line such as a coaxial cable or a balanced cable etc. is provided with regenerative repeaters in the transmission path at certain intervals along the path for regenerative repeating of signal pulses, which are attenuated or distorted during transmission over the transmission line. An amplifier in an initial stage of such a repeater is required to have an input impedance which is equal to the characteristic impedance of the transmission line over a broad frequency band, in addition to a low noise characteristic.

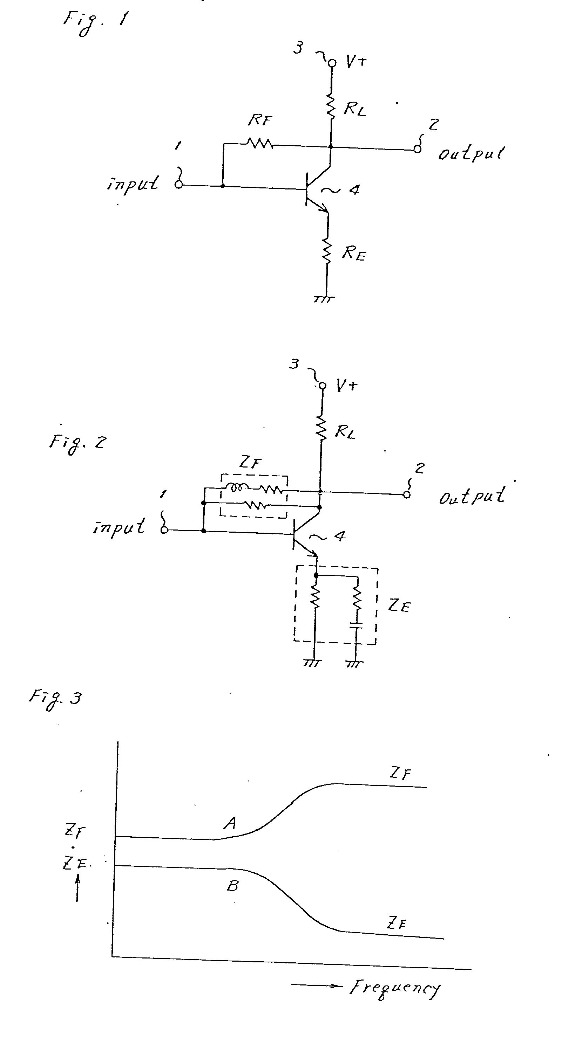

Figure 1 of the accompanying drawings is a schematic circuit diagram indicating the structure of a conventional transistor amplifier for an initial stage of a repeater. In Figure 1, 1 is an input terminal; 2 is an output terminal; 3 is a power source terminal; 4 is a transistor; $R_L$ is a load resistance; $R_F$ is a parallel resistance; $R_E$ is a series resistance.

In the circuit of Figure 1, the co-existence of a parallel feedback loop, consisting of parallel resistor $R_F$, and a series feedback loop, consisting of series resistor $R_E$, can succeed in matching the input impedance of the amplifier to the impedance of a transmission line and in realizing low noise levels. However, the circuit in Figure 1 has the following disadvantages.

-2-

(1) The parallel resistor $R_F$ and the series resistor $R_E$ must he selected so as to maintain a certain relationship in order to match impedance of the circuit to transmission line impedance and this can result in deterioration of the noise figure of the circuit.

(2) The gain of an initial stage amplifier must be large in order to make the influence of noise on a next stage amplifier small.

However, since the circuit of Figure 1 has a flat gain characteristic from low frequencies to high frequencies, if gain is increased, the overload characteristic of the circuit at a low frequency region undergoes deterioration because of a relative increase in low frequency components as a result of increased attenuation at high frequency on the transmission line, and thereby it has been impossible to increase gain sufficiently.

In a conventional amplifier circuit as shown in Figure 1, it has been impossible to suppress a noise figure to below a certain value, for the reasons mentioned above.

According to the present invention there is provided an amplifier circuit having a transistor in a grounded emitter configuration, with a parallel feedback loop between the collector and the base of the transistor, and a series feedback loop between the emitter of the transistor and ground, characterised in that the parallel feedback loop comprises a circuit having a lower impedance at low frequencies and a higher impedance at high frequencies, and in that the series feedback loop comprises a circuit having a higher impedance at low frequencies and a lower impedance at high frequencies.

An embodiment of the present invention can eliminate disadvantages of the conventional circuit described above and can offer an amplifier for the initial stage of a repeater which shows a constant input impedance over a broad frequency band with a reduced noise figure and a satisfactory overload characteristic.

A low noise amplifier circuit embodying the present invention is a grounded emitter type transistor amplifier circuit comprising a parallel feedback loop between the collector and base of a transistor and a series feedback loop between the emitter of the transistor and ground, in which the parallel feedback loop consists of a circuit which shows a low impedance at low frequency and a high impedance at high frequency, and the series feedback loop consists of a circuit which shows a high impedance at low frequency and a low impedance at high frequency.

An embodiment of this invention is suitable for use as an initial stage amplifier of a regenerative repeater in a transmission path of a digital transmission system.

Reference is made, by way of example, to the accompanying drawings, in which:-

Figure 1 is a schematic circuit diagram illustrating a conventional transistor amplifier circuit for the initial stage of a repeater;

Figure 2 is a schematic circuit diagram illustrating a low noise amplifier circuit embodying this invention;

Figure 3 is a graph illustrating frequency characteristics of a parallel impedance $Z_F$ and a series impedance $Z_E$ of the circuit of Figure 2;

Figure 4 and Figure 5 are schematic circuit diagrams of respective further embodiments of this invention;

Figure 6 and Figure 7 are detailed circuit diagrams of respective examples of embodiments of this invention;

Figure 8 is a graph illustrating the gain characteristic of the circuit shown in Figure 6; and

Figure 9 is a graph illustrating the gain characteristic of the circuit shown in Figure 7.

Figure 2 is a schematic circuit diagram of a low noise amplifier circuit embodying this invention.

-4-

In Figure 2, components similar to those in the circuit shown in Figure 1 are given the same reference symbols. $Z_F$ is a parallel impedance and $Z_E$ is a series impedance.

In the circuit of Figure 2, parallel impedance $Z_F$ connected between the base and collector of transistor 4 has a characteristic such that the absolute value of its impedance becomes high at high frequencies or low at low frequencies, for example is higher at high frequencies and lower at low frequencies. In addition, series impedance $Z_E$ inserted between the emitter and ground of transistor 4 has a characteristic such that the absolute value of its impedance becomes high at low frequencies or low at high frequencies, for example is higher at low frequencies and lower at high frequencies. The parallel impedance $Z_F$ and the series impedance $Z_E$ are selected with a view to providing that the zero point of the parallel impedance $Z_F$ is almost or approximately equal to the pole of the series impedance $Z_E$ (e.g. the frequency of the zero point coincides with that of the pole), while the pole of the parallel impedance $Z_F$ is almost or approximately equal to the zero point of the series impedance $Z_E$ (e.g. the frequency of the pole coincides with that of the zero point).

Figure 3 is a graph showing the frequency characteristics of the parallel impedance $Z_F$ and the series impedance $Z_E$. In this Figure, curve A indicates absolute value $|Z_F|$ of the parallel impedance $Z_F$ while curve B indicates absolute value $|Z_E|$ of the series impedance $Z_E$. As indicated by curves A and B of Figure 3, the frequency at which the impedance $|Z_F|$ starts to become large is almost equal to the frequency at which the impedance $|Z_E|$ starts to become small, and the frequency at which the impedance $|Z_F|$ starts to become constant is almost equal to the frequency at which the impedance $|Z_E|$ starts to become constant.

In Figure 2, the impedances $Z_F$ and $Z_E$ are indicated as comprising a resistance connected in parallel with a series connection of an inductance and a resistance or a resistance connected in parallel with a series connection of a capacitance and a resistance , these being the most simple cases where the impedances are given by a ratio of a linear polynomial. In general, however, these impedances can be selected freely under the condition that impedance $Z_F$ becomes of higher absolute value as frequency becomes high, while impedance $Z_E$ becomes of lower absolute value as frequency becomes high, and moreover the pole and zero point and zero point and pole of these impedances are almost equal.

The characteristics of an amplifier embodying this invention are explained below.

First of all, in a case in which parallel impedance $Z_F$ is infinite, namely when a parallel feedback loop does not exist, and only the series feedback loop consisting of series impedance $Z_E$ exists, input impedance $Z_{ins}$, and gain $G_s$ are approximately expressed by the following expressions, respectively.

$$Z_{ins} \fallingdotseq \beta Z_E \qquad\qquad (1)$$

$$G_s \fallingdotseq -R_L/Z_E \qquad\qquad (2)$$

Where, $\beta$ is a current amplification factor of grounded emitter transistor 4. When impedance $Z_E$ has a structure as indicated in Figure 2, input impedance $Z_{ins}$ becomes large at low frequencies but becomes small at high frequencies, while a gain $G_s$ becomes small at low frequencies but large at high frequencies.

In a case in which series impedance $Z_E$ is zero, namely when a series impedance does not exist, and only a parallel feedback loop consisting of a parallel impedance $Z_F$ exists, input impedance $Z_{inP}$ and $G_P$ in this case are respectively indicated by the following approximate expressions.

$$Z_{inP} \fallingdotseq \frac{\beta r_e Z_F}{Z_F + \beta R_L} \qquad (3)$$

$$G_P \fallingdotseq \frac{R_L Z_F}{r_e(Z_F + R_L)} \qquad (4)$$

Where, $r_e$ is emitter resistance of the transistor 4, usually from several ohms to several tens of ohms. In expression (3), impedance $Z_F$ is usually considered to be considerably larger than a load resistance $R_L$ but smaller than $\beta R_L$. Therefore input impedance $Z_{inP}$ can be approximately expressed as follows by omitting the denominator $Z_F$ from expression (3).

$$Z_{inP} = \frac{r_e Z_F}{R_L} \qquad (5)$$

Thus, input impedance $Z_{inP}$ is almost proportional to parallel impedance $Z_F$, and when impedance $Z_F$ has the structure as indicated in Figure 2, input impedance $Z_{inP}$ is small at low frequencies but large at high frequencies.

On the other hand, gain $G_P$ can be expressed as follows by transforming expression (4).

$$G_P = \frac{-1}{r_e\left(\dfrac{1}{Z_F} + \dfrac{1}{R_L}\right)} \qquad (6)$$

From the equation (6), it can be understood that a gain $G_P$ is proportional to a parallel impedance made up of impedance $Z_F$ and load resistance $R_L$. Therefore, in a case in which impedance $Z_F$ has the structure as indicated in Figure 2, gain $G_P$ is small at low frequencies but large at high frequencies.

As is obvious from the above discussions, in a case in which both a parallel impedance $Z_F$ and a series impedance $Z_E$ exist, input impedance becomes almost constant at low frequencies and at high frequencies, because the effects of parallel impedance $Z_F$ and series impedance $Z_E$ cancel each other. On the other hand, gain becomes small for low frequencies but large for high frequencies, because the effects of parallel impedance $Z_F$ and series impedance $Z_E$ are mutually combined.

A noise figure for a circuit embodying the present invention will be discussed. Generally, a noise figure for the circuit indicated in Figure 2 becomes smaller as impedance $\mid Z_F \mid$ becomes large, and as impedance $\mid Z_E \mid$ becomes small. Therefore, when impedances $Z_F$ and $Z_E$ have the structures as indicated in Figure 2, a noise figure becomes smaller as frequency becomes higher. Since total noise is proportional to a value obtained by integrating a noise figure over an operating frequency range, when a noise figure at high frequency is smaller, total noise is also smaller. Thus, total noise of an amplifier circuit embodying this invention becomes smaller than would be the case were impedances $Z_F$ and $Z_E$ composed only of resistors.

The influence of noise on a next amplifier stage will now be discussed. Generally, when a noise figure of an initial stage amplifier is taken to be $F_1$, and gain to be $G_1$, and a noise figure for a next stage amplifier to be $F_2$, a total noise figure F is expressed as follows:-

$$F = F_1 + \frac{F_2}{G_1} \qquad (7)$$

As is obvious from the above expression, when gain $G_1$ of the initial stage amplifier becomes larger, influence of noise figure $F_2$ of the next stage amplifier can be reduced. Meanwhile, as is described above, gain of the circuit indicated in Figure 2 is larger for high frequencies where noise has a larger effect. Thus, an amplifier circuit embodying this invention reduces the effect of noise on the next stage amplifier, as compared with the circuit indicated in Figure 1.

0030125

-8-

Finally, overload characteristics will be discussed. Generally, loss in a transmission line is smaller for low frequencies but larger for high frequencies. For this reason, the signal spectrum at the input of an initial stage amplifier of a repeater is mainly occupied by low frequency components to a great part, but little by high frequency components. When the initial stage amplifier amplifies equally over frequencies from low to high frequency bands, low frequency components are unnecessarily amplified, thereby bringing about an overload condition. Therefore, it is recommended to make gain smaller for low frequencies but larger for high frequencies in order to prevent an overload condition of the initial stage amplifier. Gain of an amplifier embodying this invention is smaller for low frequencies but larger for high frequencies. Therefore, an amplifier circuit embodying this invention is superior in relation to overload characteristic.

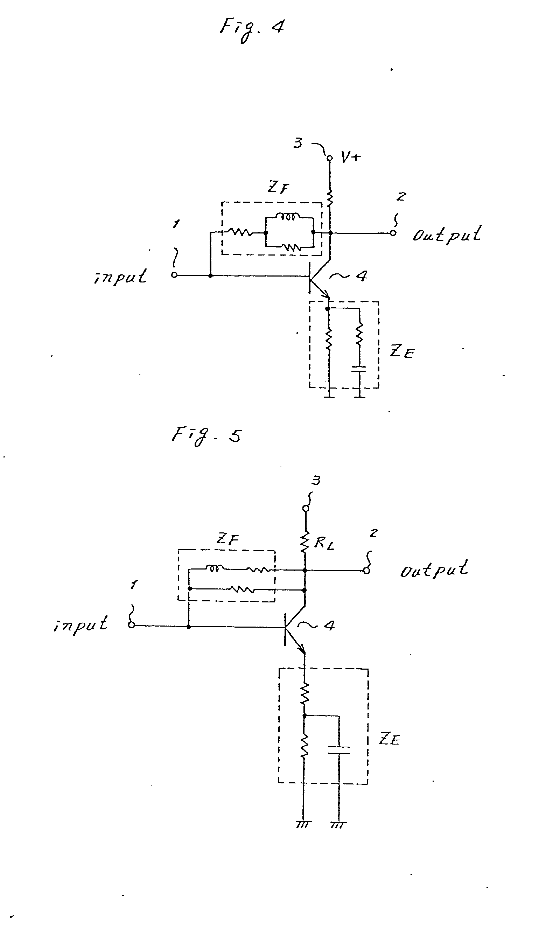

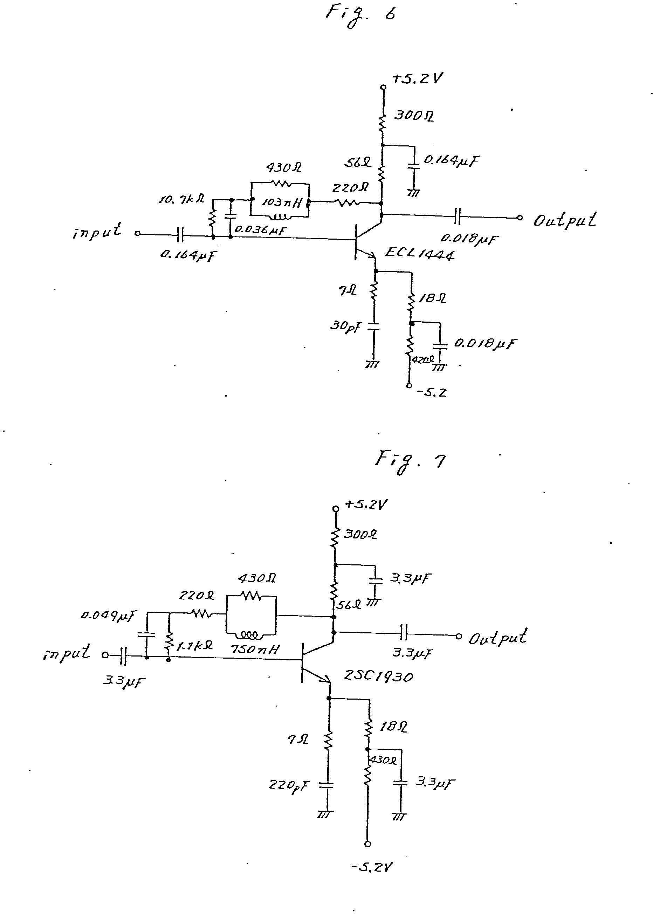

Further embodiments of this invention are illustrated in Figure 4 and Figure 5.

Figure 4 shows a structure for parallel impedance $Z_F$ different from that of Figure 2, and Figure 5 shows a structure for series impedance $Z_E$ different from that of Figure 2.

Parallel impedance $Z_F$ in Figure 4 is provided by connecting a resistance in series to a parallel connection of a resistance and an inductance. Series impedance $Z_E$ in Figure 5 is provided by connecting a resistance in series to a parallel connection of a resistance and capacitance.

Detailed practical examples of embodiments of this invention are shown in Figure 6 and Figure 7. The circuits of Figures 6 and 7 are based on the circuit structure of Figure 4 and practical component values and transistor types are indicated.

The circuit of Figure 6 is an example of a preamplifier for a repeater to be provided in a transmission line using three level signals and a bit rate of 800 Mb/s.

The circuit of Figure 7 is an example of a preamplifier for a repeater for a transmission line using bipolar signals and a bit rate of 100 Mb/s.

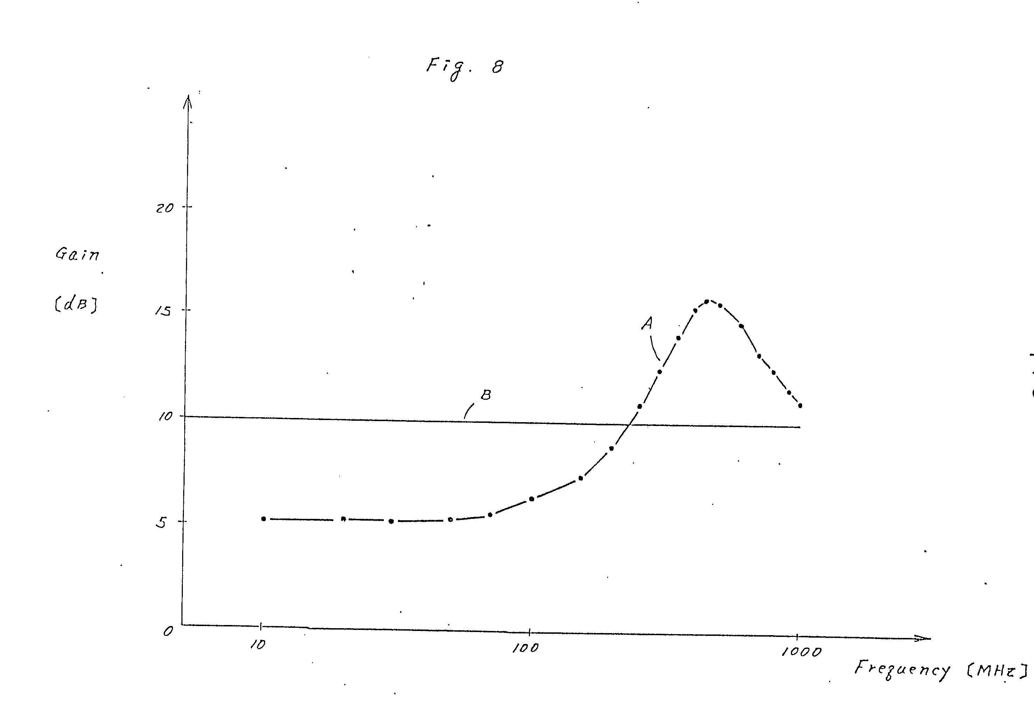

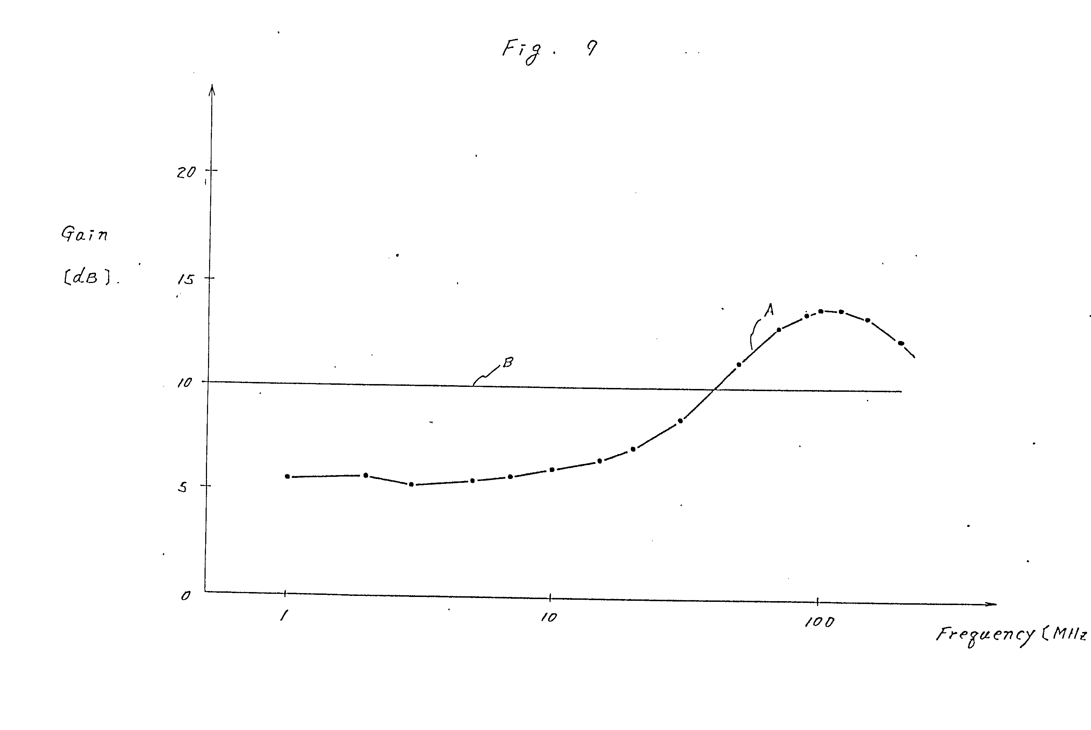

The gain characteristic of the circuit of Figure 6 is shown by curve A in Figure 8, and the gain characteristic of the circuit of Figure 7 is shown by curve A in Figure 9.

In Figure 8 and Figure 9, the horizontal axis represents frequency (MHz), while the vertical axis represents gain (dB).

For comparison, gain of the circuit of Figure 1 is indicated by curves B in Figures 8 and 9.

As will be seen from curves A in Figures 8 and 9, gain is smaller for low frequencies but larger for high frequencies as compared with gain of a conventional circuit. When gain is larger, as mentioned above, a noise figure becomes smaller, and since gain is larger in the circuits to which Figures 8 and 9 relate than it is for a conventional circuit for a wider high frequency range, a noise figure can be made smaller.

As explained above, a low noise amplifier circuit embodying this invention can provide, a low noise amplifier for the initial stage of a transmission line repeater, with good impedance matching with the transmission line because of constant input impedance for a wider frequency band and also with a small noise figure and excellent overload characteristic, by forming a circuit as illustrated in Figure 2 for example.

CLAIMS

1. An amplifier circuit having a transistor in a grounded emitter configuration, with a parallel feedback loop between the collector and the base of the transistor, and a series feedback loop between the emitter of the transistor and ground, characterised in that the parallel feedback loop comprises a circuit having a lower impedance at low frequencies and a higher impedance at high frequencies, and in that the series feedback loop comprises a circuit having a higher impedance at low frequencies and a lower impedance at high frequencies.

2. An amplifier circuit as claimed in claim 1, wherein a zero point of the parallel feedback loop circuit coincides at least approximately with a pole of the series feedback loop circuit, and a pole of the parallel feedback loop circuit coincides at least approximately with a zero point of the series feedback loop circuit.

3. An amplifier circuit as claimed in claim 1 or 2, wherein the parallel feedback loop circuit has an impedance characteristic which provides a constant lower impedance (a constant lower absolute impedance value) at low frequencies, a transitional region and a constant higher impedance (a constant higher absolute impedance value) at high frequencies, wherein the series feedback loop circuit has an impedance characteristic which provides a constant higher impedance (a constant higher absolute impedance value) at low frequencies, a transitional region and a constant lower impedance (a constant lower absolute impedance value) at high frequencies, and wherein the frequency ranges of the transitional regions of the parallel feedback loop circuit and the series feedback loop circuit substantially coincide.

4. An amplifier circuit as claimed in any preceding claim, wherein the lower impedance (lower absolute impedance value) of the parallel feedback loop circuit is greater than the higher impedance (higher absolute impedance value) of the series feedback loop circuit.

5.    An amplifier circuit as claimed in any preceding claim, wherein the parallel feedback loop circuit comprises a resistance connected in parallel with a series connection of a resistance and an inductance.

6.    An amplifier circuit as claimed in any one of claims 1 to 4, wherein the parallel feedback loop circuit comprises a resistance connected in series with a parallel connection of a resistance and an inductance.

7.    An amplifier circuit as claimed in any preceding claim, wherein the series feedback loop circuit comprises a resistance connected in parallel with a series connection of a resistance and a capacitance.

8.    An amplifier circuit as claimed in any one of claims 1 to 6, wherein the series feedback loop circuit comprises a resistance connected in series with a parallel connection of a resistance and a capacitance.

Fig. 1

Fig. 2

Fig. 3

Fig. 4

Fig. 5

Fig. 6

Fig. 7

Fig. 8

Fig. 9

Gain [dB]

Frequency (MHz)

5/5

0030125

0030125

European Patent Office

**EUROPEAN SEARCH REPORT**

Application number

EP 80 30 4252

| | DOCUMENTS CONSIDERED TO BE RELEVANT | | CLASSIFICATION OF THE APPLICATION (Int. Cl.3) |
|---|---|---|---|
| Category | Citation of document with indication, where appropriate, of relevant passages | Relevant to claim | |
| X | US - A - 3 938 057 (P.J.M. MINOT) <br> * Figures 1,3; column 2, line 13 - column 4, line 61 * <br><br> -- <br><br> FR - A - 1 254 289 (FERNSEH GmbH) <br> * Figure 4; page 2, right-hand column, lines 17-51 * <br><br> ---- | 1-3,6, 7 <br><br><br> 8 | H 03 F 1/48 <br> H 04 B 3/36 <br> H 03 F 1/26 |

TECHNICAL FIELDS SEARCHED (Int. Cl.3)

H 03 F 1
H 04 B 3

CATEGORY OF CITED DOCUMENTS

X: particularly relevant

A: technological background

O: non-written disclosure

P: intermediate document

T: theory or principle underlying the invention

E: conflicting application

D: document cited in the application

L: citation for other reasons

&: member of the same patent family, corresponding document

The present search report has been drawn up for all claims

| Place of search | Date of completion of the search | Examiner |
|---|---|---|
| The Hague | 23-02-1981 | TYBERGHIEN |

EPO Form 1503.1   06.78